Europäisches Patentamt

European Patent Office

Office européen des brevets

(11) Veröffentlichungsnummer: **0 009 610**
**A1**

(12) # EUROPÄISCHE PATENTANMELDUNG

(21) Anmeldenummer: **79103135.4**

(22) Anmeldetag: **24.08.79**

(51) Int. Cl.³: **H 01 L 21/92**
**H 01 L 23/48**

(30) Priorität: **20.09.78 DE 2840973**

(43) Veröffentlichungstag der Anmeldung:
**16.04.80 Patentblatt 80/8**

(84) Benannte Vertragsstaaten:
**AT BE CH FR GB IT NL**

(71) Anmelder: SIEMENS AKTIENGESELLSCHAFT Berlin
und München
Postfach 22 02 61
D-8000 München 22(DE)

(72) Erfinder: Andrascek, Ernst
Franz-Wolter-Strasse 13
D-8000 München 81(DE)

(72) Erfinder: Hadersbeck, Hans
Pistorini-Strasse 14
D-8000 München 90(DE)

(72) Erfinder: Hacke, Hans-Jürgen, Dipl.-Ing.
Wastl-Witt-Strasse 8b
D-8000 München 21(DE)

(54) **Verfahren zur Herstellung prüfbarer Halbleiter-Miniaturgehäuse in Bandform.**

(57) Metallische Anschlußspinne mit Höckern in Bandform. Innenkontaktierung von Chip und Anschlußspinne durch Thermokompression und/oder Ultraschall. Kapselung des kontaktierten Chips und isolierende Verbindung der Anschlußfinger in Fügetechnik, z.B. über 2 Kunststoffhalbschalen.

EP 0 009 610 A1

./...

FIG 1

SIEMENS AKTIENGESELLSCHAFT      Unser Zeichen

Berlin und München      VPA 78 P 7 1 2 6

Verfahren zur Herstellung prüfbarer Halbleiter-Miniaturgehäuse in Bandform.

Integrierte Halbleiterschaltungen können außer über
Drähte auch über Zwischensubstrate oder Spider kontaktiert
werden. Derartige Anschlußspinnen liegen entweder auf
einem Kunststoffträger vor oder sind reine metallische
Formteile, jeweils mit einem fein gerasterten Innenanschlußbereich und einem gröberen Außenanschlußbereich.
Während im erstgenannten Fall bei der Verwendung eines
Kunststoffträgers, dem sogenannten Mikropack, eine
dynamische Prüfung der kontaktierten Chips wegen der
isoliert stehenden Leiterstruktur möglich ist, kann sie
bei einem kurzgeschlossenen Metallteil nicht ohne
weiteres vorgenommen werden. Unter dynamischer Prüfung
ist die Prüfung unter normalen Betriebsbedingungen zu
verstehen.

Die Bauform Mikropack mit leitenden Strukturen auf einem
Kunststoffband bedingt Höcker auf der integrierten Halbleiterschaltung. Sie hat als Kontakt zum Chip eine Löt-

Wed 1 Plr/15.9.1978

verbindung und liegt wegen des Substratbandes aus Kunststoff, z. B. Polyimid, relativ hoch in den Materialkosten. Bei der Kontaktierung über Metallspider wird die Außenkontaktierung jedoch immer mit dynamisch ungeprüften Chips auf Systemträgern, die später getrennt und umspritzt werden, oder auf Schaltungen vorgenommen.

Beim Einsatz von integrierten Schaltungen der herkömmlichen Bauformen wird besonders mit zunehmender Komplexität und steigender Anschlußzahl das Verhältnis von Einbaufläche zur notwendigen Chipfläche immer ungünstiger. Daraus geht hervor, daß die Fortschritte der Integration bei Halbleiterschaltungen nur bedingt genutzt werden können, wenn es nicht gelingt, zu neuen Gehäusebauformen und Aufbautechniken zu kommen. Es ist zwar möglich, unverkapselte Halbleiterchips direkt in Schichtschaltungen oder Leiterplatten einzubauen und elektrisch anzuschließen. Dabei treten jedoch besonders bei mehreren integrierten Schaltungen je Baugruppe eine Reihe von Problemen auf.

Der Erfindung liegt die Aufgabe zugrunde, ein Verfahren zur Herstellung einer eigenständigen Bauform eines in einer Metallspinne kontaktierten Chips zu schaffen, die elektrisch geprüft und mechanisch weitgehend geschützt vom Band verarbeitet werden kann. Diese eigenständige Bauform soll ferner für eine Bestückung in einem Automaten aufgenommen und dann beliebige Leiterplatten mit diesen integrierten Halbleiterschaltungen versehen werden können, und zwar mittels einer Löt-, Ultraschall- bzw. Thermokompressionsverbindungstechnik. Die Herstellung derartiger miniaturisierter Gehäuse im Bandformat geschieht nach der Erfindung in Kombination folgender Verfahrensschritte:
Herstellung einer metallischen Anschlußspinne in Bandform (Systemträger), vorzugsweise in Ätztechnik, wobei gleichzeitig die Höcker mit erzeugt werden. Als Material sind insbesondere Kupfer und seine Legierungen ohne besondere
Oberflächenschicht geeignet. Es können jedoch auch andere
kontaktierbare Metalle und Oberflächenausführungen verwendet werden.

Die Innenkontaktierung von Chip und Anschlußspinne erfolgt
als weiterer Verfahrensschritt durch Thermokompression
und/oder Ultraschall. Aufgewachste und gesägte Chips mit
passivierter Oberfläche und Kontaktfenstern, jedoch ohne
gesonderte Höcker, sowie die Spinnen im perforierten Band
erlauben eine automatische Kontaktierung. Die Verbindungsstelle ist unempfindlich gegen Temperaturbelastungen.

Die Kapselung des kontaktierten Chips und isolierende Verbindung der Anschlußfinger kann schließlich als nächster
Schritt in Fügetechnik, vorzugsweise über zwei Kunststoffhalbschalen erfolgen, durch die mindestens ein isolierender Steg zum Arbeitsrand der Metallspinne erzeugt wird.
Dieser Steg muß hinsichtlich Steifigkeit und Genauigkeit
in der Lage sein, das gekapselte Teil auch nach dem Abtrennen der leitenden Strukturen in seiner Position zu
halten.

Der Vorteil des Verfahrens nach der Erfindung liegt vor
allem darin, daß damit kostengünstige Anschlußspinnen mit
Höckern in Bandform hergestellt werden können, die auch
im Bandformat elektrisch prüfbar sind. Die Erzeugung der
Höcker ist ohne Mehraufwand ätztechnisch durchführbar. Bei
diesem Verfahren sind keine Höcker mehr auf dem Chip
nötig. Daher ist die Verwendung von Standardbausteinen
möglich. Die in Thermokompression hergestellten Innenkontakte sind, z. B. bei Außenlötung, nicht temperaturgefährdet. Außerdem ist die Kapselung typunabhängig,
z. B. mit Universal-Kunststofformteilen, durchzuführen.
Schließlich können entsprechend hergestellte Mikropacks
auch bei extremen Umweltbedingungen Verwendung finden, da der Chip bei Kapselung mechanisch nicht geschädigt werden kann. Die Kapselung kann neben mechanischem Schutz auch zur optischen Abdichtung dienen und erlaubt die Anwendung von Durchbrüchen. Ein weiterer Vorteil sind freiliegende Außenanschlüsse und die Möglichkeit der Verwendung in verschiedenen Einbaulagen. Darüber hinaus erzielt man so äußerst geringe Einbaumaße.

Als Bedarfsarbeitsgang ist in gekapseltem ungetrenntem Zustand das Aufbringen jeder gewünschten Endoberfläche auf galvanischem Wege möglich. Da alle Anschlüsse noch metallisch verbunden sind, der Innenbereich jedoch gekapselt ist, kann auf einfache Weise selektiv auf die Außenanschlüsse eine für die Weiterverarbeitung günstige Oberfläche aufgebracht werden.

Nach einer weiteren Ausführung der Erfindung wird statt der Kapselung des kontaktierten Chips die Metallspinne mit dem Chip einseitig auf eine Kunststoffolie aufgesiegelt, die Öffnungsschlitze für die Außenanschlüsse aufweist.

Nach dem Herstellungsverfahren nach der Erfindung erfolgt das Freischneiden der Außenanschlüsse und damit Trennen des Miniaturgehäuses aus dem leitenden Verbund. Es wird jetzt nur noch durch die nichtleitenden Stege in Position und Bandformat gehalten. Selbstverständlich ist auch eine Vereinzelung und ein Absetzen in Magazine oder auf Transferbänder möglich. Daran schließt sich eine dynamische elektrische Prüfung an. Die Weiterverarbeitung vom Band und das Einsetzen in Schichtschaltungen, gedruckte Schaltungen oder Systemträger kann durch Löten, Schweißen, Klemmen, Kleben usw. erfolgen.

Die Erfindung wird anhand der Figuren erläutert. Es zeigen:

Figur 1 einen Ausschnitt eines Systemträgers mit miniaturisiertem Gehäuse in der Draufsicht und

Figur 2 die dazugehörige Vorderansicht.

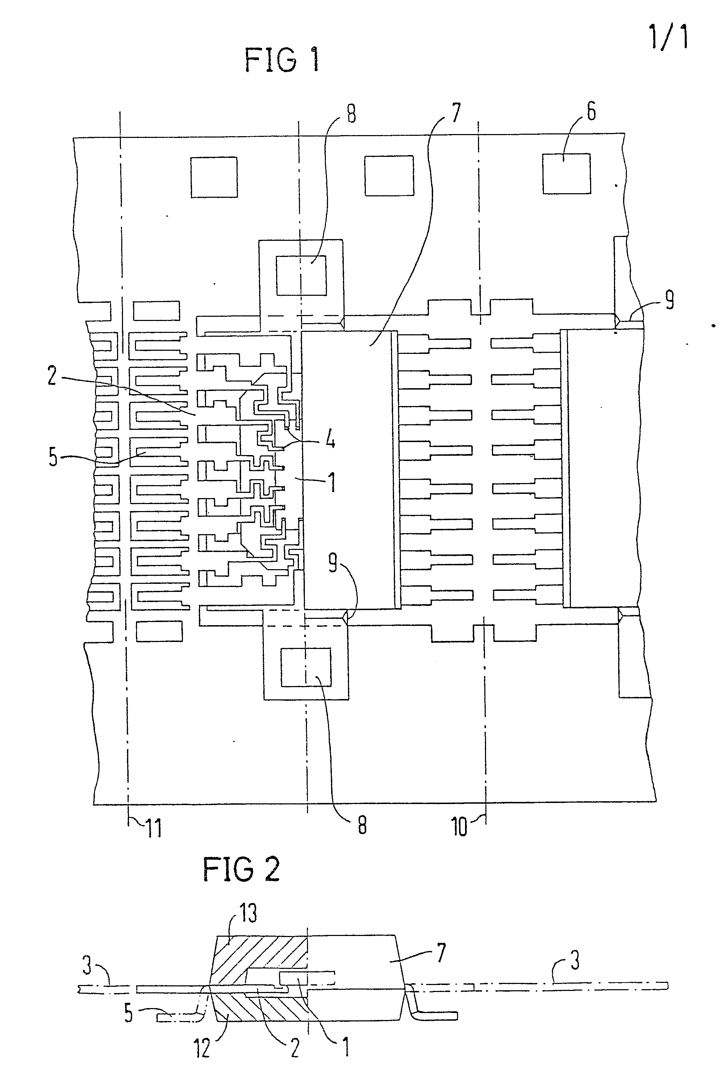

In der Figur 1 ist ein Halbleiterspeicherchip 1 auf einem bandförmigen metallischen Zwischenträger 3 angeordnet. Die Innenanschlüsse 4 gehen in die Außenanschlüsse 5 über. Mit 6 ist die Filmperforation markiert. Mit 7 ist die Hälfte eines Kunststoffgehäuses bezeichnet, das im Mittelbereich 2 und über Haltestege 8 mit dem Arbeitsrand des Systemträgers 3 verbunden ist. 9 bezeichnet eine Sollbruchstelle. 10 markiert eine Linie "Metallstruktur getrennt" und 11 "Metallstruktur zusammenhängend mit Endoberfläche". Das Kunststoffgehäuse 7 besteht z. B. aus zwei Halbschalen, und zwar einem Boden 12 und einem Deckel 13.

Die Halbschalen 12, 13 werden als Kunststofformteile aus geeignetem Material durch Pressen oder Spritzen hergestellt, wobei je nach Bedarf für den Chip notwendige Vertiefungen oder Durchbrüche vorzusehen sind.

2 Patentansprüche
2 Figuren

Patentansprüche.

1. Verfahren zur Herstellung prüfbarer Halbleiter-
Miniaturgehäuse in Bandform,   g e k e n n z e i c h -
n e t   d u r c h   die Kombination folgender Verfahrensschritte:

Herstellung von Anschlußspinnen mit Innenanschlüssen (4)
und Außenanschlüssen (5) in Form bandförmiger metallischer
Zwischenträger (3), vorzugsweise in Ätztechnik,
Innenkontaktierung von Chip (1) und Anschluspinne durch
Thermokompression und/oder Ultraschall und
Kapselung des kontaktierten Chips und isolierende Verbindung der Anschlußfinger in Fügetechnik über vorzugsweise zwei Kunststoffhalbschalen (12, 13), durch die
mindestens ein isolierender Steg (8) zum Arbeitsrand
des Metallzwischenträgers (3) erzeugt wird und anschließendes Freistanzen der Außenanschlüsse des Systemträgers.

2. Verfahren nach Anspruch 1,   d a d u r c h   g e -
k e n n z e i c h n e t ,   daß statt der Kapselung des
kontaktierten Chips die Metallspinne mit dem Chip einseitig auf eine Kunststoffolie aufgesiegelt wird, die
Öffnungsschlitze für die Außenanschlüsse aufweist.

FIG 1

FIG 2

0009610

Nummer der Anmeldung

Europäisches
Patentamt

EUROPÄISCHER RECHERCHENBERICHT

EP 79 103 135.4

| Kategorie | Kennzeichnung des Dokuments mit Angabe, soweit erforderlich, der maßgeblichen Teile | betrifft Anspruch |
|---|---|---|
| | DE - A - 2 138 797 (MOTOROLA) <br> * Ansprüche 1 bis 4; Seiten 4, 5; Fig. 4 bis 7 * | 1 |
| | DE - A - 2 315 711 (LICENTIA) <br> * Ansprüche 1, 2; Fig. 1 bis 4 * | 1 |
| | DE - B2 - 2 158 651 (SIGNETICS) <br> * Ansprüche 1, 3; Spalte 3, Zeilen 25 bis 28 ; Spalte 4, Zeile 66 bis Spalte 5, Zeilen 12; Spalte 6, Zeile 42 bis Spalte 7, Zeile 22; Fig. 4 bis 6 * | 1 |
| | DE - B - 1 514 768 (ITT) <br> * Spalte 4, Zeilen 1 bis 10, Zeilen 29 bis 36 * | 1 |
| | DE - B - 1 813 164 (MOTOROLA) <br> * Ansprüche 1, 2, 4, 6; Spalte 7, Zeilen 3 bis 51; Spalte 8, Zeilen 34 bis 44; Fig. 2, 3a, 4 * | 1,2 |
| | GB - A - 1 492 015 (RAYTHEON) <br> * Ansprüche 1, 2, 19, 21 * | 1 |
| | GB - A - 1 262 511 (GENERAL ELECTRIC) <br> * Ansprüche 27, 28; Seite 3, Zeilen 17 bis 128, Seite 4, Zeilen 77 bis 104; Fig. 3 bis 5, 11, 12 * | 1,2 |

**EINSCHLÄGIGE DOKUMENTE**

**KLASSIFIKATION DER ANMELDUNG (Int.Cl.3)**

H 01 L 21/92
H 01 L 23/48

**RECHERCHIERTE SACHGEBIETE (Int. Cl.3)**

H 01 L 21/92
H 01 L 23/48

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

X Der vorliegende Recherchenbericht wurde für alle Patentansprüche erstellt.

| Recherchenort | Abschlußdatum der Recherche | Prüfer |
|---|---|---|
| Berlin | 29-11-1979 | ROTHER |

EPA form 1503.1  06.78